# EUROPÄISCHE PATENTANMELDUNG

(11) **EP 1 021 076 A2**
(43) Veröffentlichungstag der Anmeldung: **19.07.2000**
(21) Anmeldenummer: 99124449.2
(22) Anmeldetag: 08.12.1999
(51) Int. Cl.: H05K 7/14

(54) **Befestigungsanordnung für eine Platte in einem Gehäuse**

(30) Priorität: 16.01.1999 DE 19901534
(71) Anmelder: DaimlerChrysler AG, 70567 Stuttgart (DE)
(72) Erfinder: Baur, Richard, 85276 Pfaffenhofen (DE); Fendt, Günter, 86529 Schrobenhausen (DE); Wöhrl, Alfons, 86529 Schrobenhausen (DE); Wörle, Engelbert, 86556 Kühbach (DE)
(74) Vertreter: Kolb, Georg

(57) **Zusammenfassung**

Eine Befestigungsanordnung 10 ist dadurch gebildet, daß ein Stift 13 in eine Gehäuseausformung 14 eines Gehäuses 11 eingreift und gleichzeitig eine Durchgangsbohrung 15 einer Platte 12 durchgreift, die im Gehäuse 11 zu befestigen ist. Der Stift 13 ist bevorzugt konisch ausgebildet, und wird er in die Gehäuseausformung 14 eingetrieben, so verkeilt er sich mit der Durchgangsbohrung 15 der Platte 12 und in der Gehäuseausformung 14.

## Beschreibung

Die Erfindung betrifft eine Befestigungsanordnung in einem Gehäuse mit Haltemitteln, die eine Platte im Gehäuse lagefixieren und halten.

Eine derartige Befestigungsanordnung ist durch das Deutsche Gebrauchsmuster DE 93 21 190 U1 bekanntgeworden.

Elektromechanische und/oder elektronische Bauteile, sowie Leiterplatten werden in großer Anzahl in der Kraftfahrzeug-Automobilindustrie in Gehäusen untergebracht, damit sie vor Beschädigungen und Verschmutzungen jedweder Art geschützt sind. Die in einem Gehäuse untergebrachten Bauteile und/oder Platinen sollen dort erschütterungsstabil befestigt sein.

Die aus der DE 93 21 190 U1 bekannte Befestigungsanordnung sieht vor, Bauteile, wie Schaltungsträgerplatten in einem Gehäuse über Kontaktstifte zu halten, die über Federklemmen gesichert sind. Die Federklemmen müssen einerseits so beschaffen sein, daß sie die Kontaktstifte und die Schaltungsträgerplatte umgreifen, und andererseits müssen sie gewährleisten, daß sie sich am Kontaktstift nicht verschieben. Deshalb müssen diese Federklemmen eine große Klemmkraft sowohl auf den Kontaktstift, wie auch auf die Schaltungsträgerplatte ausüben.

Aufgabe der Erfindung ist es, eine Befestigungsanordnung für Platten zu schaffen, die kostengünstig herzustellen ist und vollautomatisch mit einer hohen Prozeßsicherheit einsetzbar ist.

Diese Aufgabe wird erfindungsgemäß dadurch gelöst, daß die Haltemittel aus einem oder mehreren Stiften gebildet sind, die in Gehäuseausformungen des Gehäuses einschiebbar sind, wobei die Gehäuseausformungen die Platte durchgreifen oder die Gehäuseausformungen mit Durchgangsbohrungen der Platte fluchten und daß bei eingeschobenem Stift die Platte kraftschlüssig, also unverrückbar im Gehäuse gehalten ist.

Die erfindungsgemäße Befestigungsanordnung hat damit den wesentlichen Vorteil, daß zur Befestigung einer Platte in einem Gehäuse keine zusätzlichen Klemmmittel, wie Schrauben, Federklemmen usw. benötigt werden. Der für die erfindungsgemäße Befestigung vorgesehene Stift durchgreift die zu befestigende Platte und verspannt die Platte unverrückbar mit dem Gehäuse, in dem der Stift in eine Gehäuseausformung eingreift, in die er mehr oder weniger stark eingeschoben werden kann. Wird der Stift in die Gehäuseausformung eingeschoben, so verkeilt oder verpreßt er sich mit der Gehäuseausformung und direkt oder indirekt auch mit der Platte. Damit ist eine sichere Befestigungsverbindung geschaffen, die einfachst aufgebaut ist, aus denselben Materialien wie die Gehäuseausformungen hergestellt werden kann, automatisch setzbar ist und deshalb Schaltungsträgerplatten sicher halten kann, weil der Stift über ein Betätigungsmittel nur in die Gehäuseausformung eingedrückt werden muß, nachdem zuvor die Platte im Bereich einer Durchgangsbohrung über einen Zapfen der Gehäuseausformung geschoben wurde oder die Platte an die Gehäuseausformung derart angepasst wur de, daß die Gehäuseausformung mit der Durchgangsbohrung fluchtet und der Stift sowohl durch die Durchgangsbohrung als auch in die Gehäuseausformung geschoben werden kann.

In weiterer Ausgestaltung der Erfindung ist der Stift über seine axiale Erstreckung konisch verlaufend ausgebildet und in einen Freiraum der Gehäuseausformung einschiebbar, die über ihre axiale Erstreckung mindestens Freiraumabschnitte aufweist, die einen Innendurchmesser aufweisen, der kleiner als der Außendurchmesser des Stiftes im in die Gehäuseausformung eingeschobenen Zustand ist.

Mit einer derartigen Ausgestaltung eines Stiftes läßt sich eine Befestigung der Platte im Gehäuse über eine Verspannung oder Verpressung einfachst erreichen. Für eine erfindungsgemäße Befestigung kann der Stift auch, über seine axiale Erstreckung gesehen, zylindrisch ausgebildet und in eine Gehäuseausformung einschiebbar sein, die sich über die axiale Erstreckung derart verengt, daß der Außendurchmesser des Stiftes beim Eintritt in die Gehäuseausformung kleiner ist als der Innendurchmesser der Gehäuseausformung am freien Ende und sich ein Freiraumabschnitt der Gehäuseausformung auf einen Innendurchmesser verengt, der kleiner als der Außendurchmesser des Stiftes ist.

Ist der Freiraum in einer Gehäuseausformung sich verengend konisch verlaufend ausgebildet, so lassen sich für eine Verklemmung der Platte im Gehäuse auch zylindrische Stifte einsetzen.

Bevorzugt sind die zu befestigenden Platten im Gehäuse Schaltungsträgerplatten, die elektromechanische bzw. elektronische Bauelemente tragen. Über eine derartige Anordnung der Platte im Gehäuse sind die auf der Schaltungsträgerplatte angeordneten Bauelemente lagestabil im Gehäuse festgelegt.

In weiterer Ausgestaltung der Erfindung ist das Gehäuse bei im Gehäuse befestigter Platte über einen Deckel verschließbar, der einen Absatz aufweist, der bei verschlossenem Gehäuse und eingeschobenem Stift auf der Stirnseite des freien Endes des Stiftes spielfrei anliegt.

Diese Anordnung hat den zusätzlichen Vorteile, daß der in der Gehäuseausformung verkeilte Stift noch zusätzlich über einen Absatz in seiner gewünschten Positionslage gesichert ist. Ein derartig gesicherter Stift kann sich auch auf Grund von schweren Erschütterungen, die auf das Gehäuse einwirken, nicht mehr lösen.

In einer anderen Ausführungsform ist zum Verschließen des Gehäuses ein Deckel vorgesehen, an dessen Unterseite der Stift angeformt ist.

Mit einer derartigen Ausgestaltung werden die zu verbauenden Einzelteile nochmals reduziert, und die Verklemmung der Platte im Gehäuse findet erst dann statt, wenn der Deckel auf das Gehäuse gesetzt wird und mit dem Deckel das Gehäuse verschlossen wird. Die Gehäuseausformungen im Gehäuse und der Stift auf der Unterseite des Deckels sind derart aufeinander abgestimmt, daß beim Verschließen des Gehäuses der Stift auf der Unterseite des Deckels durch eine Durchgangsbohrung der Platte greift und sich verkeilend in die darunterliegende Gehäuseausformung einschiebt.

In bevorzugter Ausgestaltung der Erfindung weist der Stift auf der Außenumfangsfläche aufgerauhte Abschnitte und/oder Vorsprünge auf.

Dies hat den Vorteil, daß sich der Stift in der Gehäuseausformung noch zusätzlich über eine Verrastung, Verklettung oder über einen verstärkten Reibschluß halten kann.

Der Stift und das Gehäuse sind bevorzugt aus Kunststoff oder aus einem Karbonfaserverbundmaterial hergestellt, weil mit diesen Materialien eine Gewichtsreduzierung sowohl für die Baugruppe insgesamt wie auch für die Befestigungsanordnung erreicht werden kann.

Besonders vorteilhaft ist die erfindungsgemäße Befestigungsanordnung dann aufgebaut, wenn die Gehäuseausformungen radial verlaufende Schlitze aufweisen, die sich in axialer Richtung der Gehäuseausformung zumindest abschnittsweise erstrecken.

Dies hat den Vorteil, daß sich Abschnitte der Gehäuseausformungen wie elastische Zungen bewegen können, und wird ein Stift in eine derartige Gehäuseausformung eingetrieben, so weitet er die Gehäuseausformung in dem geschlitzten Bereich auf und die einzelnen Abschnitte der Gehäuseausformung drücken sich an die Innenoberfläche der Durchgangsbohrungen der Platte, so daß die Platte mit den Gehäuseausformungen des Gehäuses verspannt ist.

Weitere Vorteile ergeben sich aus der Beschreibung und der beigefügten Zeichnung. Ebenso können die vorstehend genannten und die noch weiter aufgeführten Merkmale erfindungsgemäß jeweils einzeln oder in beliebigen Kombinationen miteinander verwendet werden. Die erwähnten Ausführungsformen sind nicht als abschließende Aufzählung zu verstehen, sondern haben vielmehr beispielhaften Charakter.

Die Erfindung wird anhand von Ausführungsbeispielen in der Zeichnung näher erläutert. Es zeigt:
- Fig. 1: eine Zusammenstellung einer erfindungsgemäßen Befestigungsanordnung an einem Teilabschnitt eines Gehäuses, wobei die einzelnen Teile noch einander lose zugeordnet sind;
- Fig. 2: eine Zusammenstellung der erfindungsgemäßen Befestigungsanordnung mit in eine Gehäuseausformung eingeschobenem Stift;
- Fig. 3: eine Zusammenstellung einer erfindungsgemäßen Befestigungsanordnung mit zusätzlichem Sicherungsmittel über einen Deckel, der auf einen eingeschobenen Stift wirkt;
- Fig. 4: eine weitere Ausführungsform einer erfindungsgemäßen Befestigungsanordnung mit einem Stift, der in eine Gehäuseausformung einschiebbar ist;
- Fig. 5: eine Draufsicht auf eine Verbindung zwischen einer Platte, Endabschnitten einer Gehäuseausformung und einem Stift;
- Fig. 6: eine weiteres Beispiel einer Befestigungsanordnung mit einem Stift, der zusätzliche Haltemittel auf seiner Außenoberfläche aufweist;
- Fig. 7: eine erfindungsgemäße Befestigungsanordnung, bei der ein Stift materialschlüssig auf der Unterseite eines Deckels angeformt ist und in eine Gehäuseausformung greift.

Die einzelnen Figuren der Zeichnung zeigen den erfindungsgemäßen Gegenstand teilweise stark schematisiert und sind nicht maßstäblich zu verstehen.

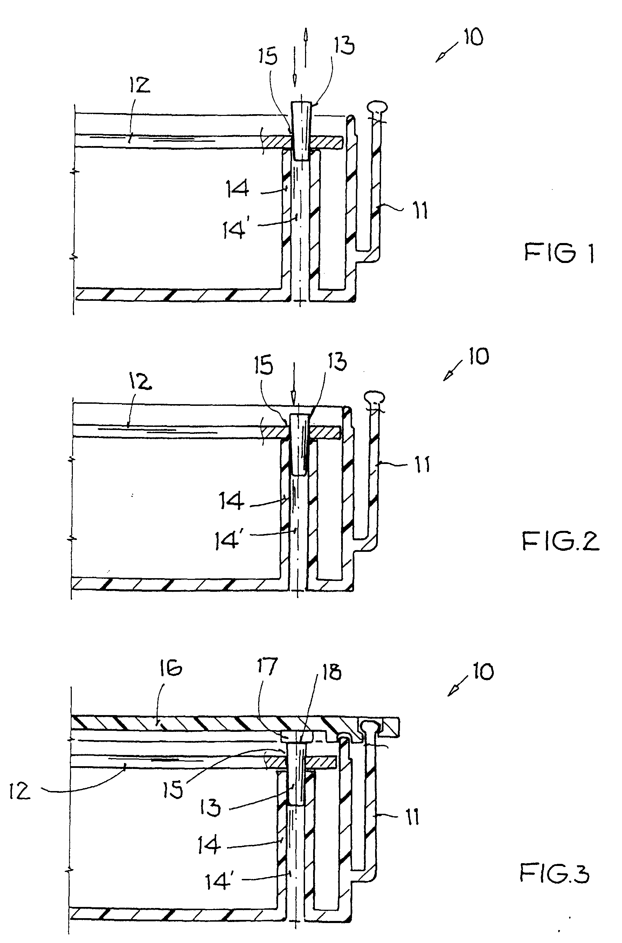

Fig. 1 zeigt eine Befestigungsanordnung 10 mit einem Gehäuse 11, einer Platte 12 und einem Stift 13, wie er in eine Gehäuseausformung 14 eingreift. Von dem Gehäuse 11 und der Platte 12 ist in der Figur nur ein kleiner Ausschnitt gezeigt. Es versteht sich, daß an einer Platte 12 mehrere erfindungsgemäße Befestigungsanordnungen 10 ausgebildet sein können. Der Stift 13 kann in Richtung des strich-punktierten Pfeils aus der Gehäuseausformung 14 herausgezogen werden und er kann in Richtung des durchgezogenen Pfeils in die Gehäuseausformung 14 eingedrückt werden. Wird der Stift 13 in den Freiraum 14' der Gehäuseausformung 14 eingedrückt, so verkeilt bzw. verpreßt sich der Stift im Bereich der Durchgangsbohrung 15 mit der Platte 12 und in der Gehäuseausformung 14. Über diese Verkeilung bzw. Verpressung ist eine bleibende, insbesondere kraftschlüssige und sichere Befestigungsverbindung zwischen der Platte 12 und dem Gehäuse 11 geschaffen.

Fig. 2 zeigt, wie der Stift 13 die Platte 12 im Gehäuse 11 im Bereich der Gehäuseausformung 14 hält, indem der Stift 13 in Pfeilrichtung durch die Durchgangsbohrung 15 so weit in den Freiraum 14' eingedrückt wurde, bis die gewünschte Verspannung bzw. Verpressung von Stift 13 und Durchgangsbohrung 15 sowie Gehäuseausformung 14 erreicht worden ist. Der Stift 13 kann als loses zusätzliches Teil in die Gehäuseausformung 14 eingeschoben werden, oder er ist über eine Soll-Bruchstelle mit der Platte 12 verbunden, die dann aufbricht, wenn der Stift 13 in Pfeilrichtung in den Freiraum 14' eingeschoben wird.

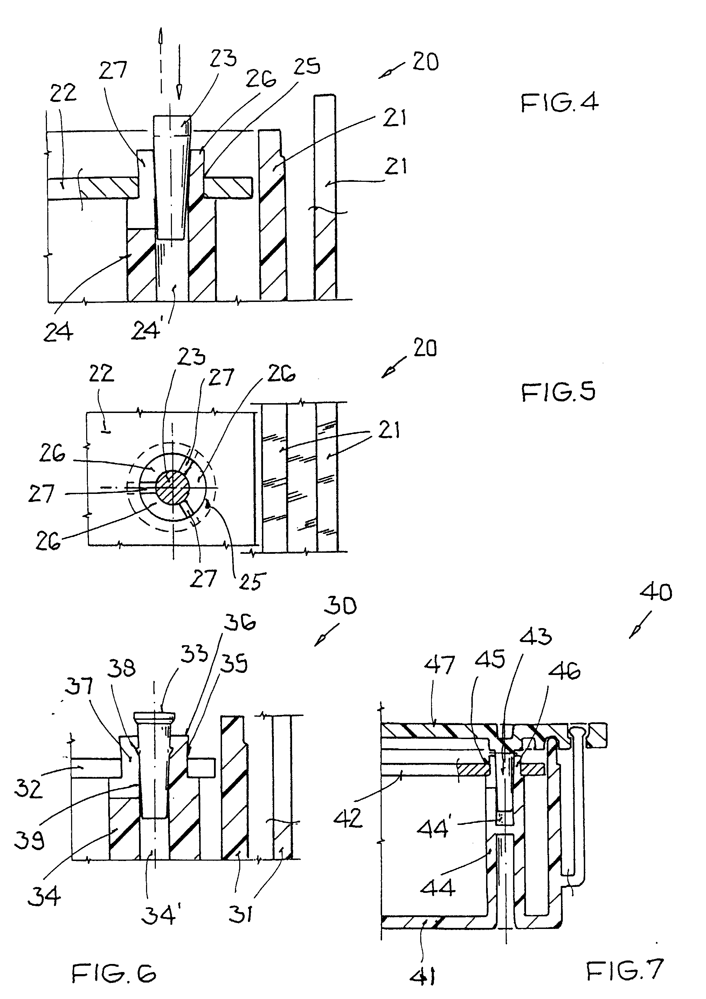

Fig. 3 zeigt die erfindungsgemäße Befestigungsanordnung 10 am Gehäuse 11 mit einem in die Durchgangsbohrung 15 und den Freiraum 14' eingeschobenen Stift 13. Der Stift 13 hält unmittelbar die Platte 12 an der Gehäuseausformung 14. Ein Deckel 16, der das Gehäuse 11 verschließt, weist, in den Innenraum gerichtet, einen Absatz 17 auf, der auf einer Stirnseite 18 des Stiftes 13 spielfrei aufliegt. Damit ist der Stift 13 lagegesichert.

Fig. 4 zeigt eine weitere Ausgestaltung einer erfindungsgemäßen Befestigungsanordnung 20 mit einem Abschnitt eines Gehäuses 21 und einem Abschnitt einer Platte 22. Ein Stift 23 ragt in eine Gehäuseausformung 24, die einen Freiraum 24' aufweist.

Eine Durchgangsbohrung 25 der Platte 22 ist über einen hohlzapfenartigen Endabschnitt 26 der Gehäuseausformung 24 geschoben. Der Stift 23 kann an der Gehäuseausformung 24 angespritzt sein, so daß die zu befestigende Platte 22 nur noch über den Stift 23 im Bereich der Durchgangsbohrung 25 geschoben werden muß, bis die Platte 22 auf einem Vorsprung der Gehäuseausformung 24 aufliegt. Der Endabschnitt 26 weist einen Schlitz 27 auf, der den Endabschnitt 26 elastischer gestaltet. Der Stift 23 kann in Richtung des strich-punktierten Pfeiles aus der Gehäuseausformung 24 herausgezogen werden oder in Richtung des durchgezogen gezeichneten Pfeiles in den Freiraum 24' der Gehäuseausformung 24 eingeschoben werden.

Fig. 5 zeigt eine Draufsicht der Befestigungsanordnung 20 aus Fig. 4. Ein Teilausschnitt zeigt das Gehäuse 21 und die Platte 22, wie sie im Bereich der Durchgangsbohrung 25 über die Endabschnitte 26 geschoben ist. Der Stift 23 ist in den Hohlraum eingeschoben, der von den Endabschnitten 26 in radialer Richtung begrenzt ist. Die Endabschnitte 26 bilden einen Gehäusezapfen mit einem Hohlraum, der radial nach außen gerichtete Schlitze 27 aufweist. Die Endabschnitte 26 können sich somit verbessert weiten, wenn der Stift 23 in die Gehäuseausformung eingetrieben wird.

Fig. 6 zeigt eine Befestigungsanordnung 30 mit einem Gehäuse 31 und einer Platte 32, die über einen Stift 33 miteinander verbindbar sind. Der Stift 33 ist in eine Gehäuseausformung 34 einschiebbar, die einen Freiraum 34' aufweist. Eine von mehreren Durchgangsbohrungen 35 der Platte 32 ist über Endabschnitte 36 des hohl ausgebildeten Gehäusezapfens geschoben, der die Gehäuseausformung 34 im Endbereich bildet. An der Außenumfangsoberfläche des Stiftes 33 sind Vorsprünge 38 und aufgerauhte Abschnitte ausgebildet, die an der Innenoberfläche der Gehäuseausformung 34 besonders gut haften, wenn der Stift 33 in mit durchgezogener Linie gezeichneter Pfeilrichtung eingetrieben wird. Der Stift 33 treibt dabei die Endabschnitte 36 auseinander, so daß sich diese mit der Innenoberfläche der Durchgangsbohrung 35 verspannen können. Mit einem strich-punktierten Pfeil ist die Richtung dargestellt, in der der Stift 33 aus der Gehäuseausformung 34 herausgezogen werden kann.

Fig. 7 zeigt eine erfindungsgemäße Befestigungsanordnung 40 mit einem Gehäuse 41 und einer Platte 42. Die Platte 42 ist am Gehäuse 41 über einen Stift 43 gehalten, der, wie die Figur zeigt, in eine Gehäuseausformung 44 ragt, die einen Freiraum 44' bildet. Der Freiraum 44' ist als Sackloch ausgestaltet. Die Gehäuseausformung 44 durchgreift eine Durchgangsbohrung 45 der Platte 42 indem Endabschnitte 46 der Gehäuseausformung 44 über die Platte 42 hinausragen. Der Stift 43 ist auf der Unterseite eines Deckels 47 ausgebildet. Wird der Deckel 47 auf das Gehäuse 41 gesetzt und mit dem Gehäuse verrastet, so greift der Dekkel 47 mit einem oder mehreren Stiften 43 in entsprechende Gehäuseausformungen 44 und verspannt gleichzeitig die Platte 42 mit dem Gehäuse 41, damit die Platte 42 unverrückbar in dem Gehäuse 41 gehalten ist.

Eine Befestigungsanordnung 10 ist dadurch gebildet, daß ein Stift 13 in eine Gehäuseausformung 14 eines Gehäuses 11 eingreift und gleichzeitig eine Durchgangsbohrung 15 einer Platte 12 durchgreift, die im Gehäuse 11 zu befestigen ist. Der Stift 13 ist bevorzugt konisch ausgebildet, und wird er in die Gehäuseausformung 14 eingetrieben, so verkeilt er sich mit der Durchgangsbohrung 15 der Platte 12 und in der Gehäuseausformung 14.

## Patentansprüche

1. Befestigungsanordnung in einem Gehäuse (10; 20; 30; 40) mit Haltemitteln, die eine Platte (12; 22; 32; 42;) im Gehäuse (11; 21; 31; 41) lagefixieren und halten,
dadurch gekennzeichnet,
daß die Haltemittel aus einem oder mehreren Stiften (13; 23; 33; 43) gebildet sind, die in Gehäuseausformungen (14; 24; 34; 44) des Gehäuses (11; 21; 31; 41) einschiebbar sind, wobei die Gehäuseausformungen (14; 24; 34; 44) die Platte (12; 22; 32; 42) durchgreifen oder die Gehäuseausformungen (14; 24; 34; 44) mit Durchgangsbohrungen (15; 25; 35; 45) der Platte (12; 22; 32; 42) fluchten, und daß bei eingeschobenem Stift (13; 23; 33; 43) die Platte (12; 22; 32; 42) kraftschlüssig im Gehäuse (11; 21; 31; 41) gehalten ist.

2. Befestigungsanordnung nach Anspruch 1, dadurch gekennzeichnet, daß der Stift (13; 23; 33; 43) über seine axiale Erstreckung konisch verlaufend ausgebildet und in einen Freiraum (14'; 24'; 34'; 44') der Gehäuseausformung (14; 24; 34; 44) einschiebbar ist, die über ihre axiale Erstreckung mindestens Freiraumabschnitte aufweist, die einen Innendurchmesser aufweisen, der kleiner als der Außendurchmesser des Stiftes (13; 23; 33; 43) im in die Gehäuseausformung (14; 24; 34; 44) eingeschobenen Zustand ist.

3. Befestigungsanordnung nach Anspruch 1, dadurch gekennzeichnet, daß der Stift über seine axiale Erstreckung gesehen zylindrisch ausgebildet und in eine Gehäuseausformung einschiebbar ist, die sich über die axiale Erstreckung derart verengt, daß der Außendurchmesser des Stiftes beim Eintritt in die Gehäuseausformung kleiner ist als der Innendurchmesser der Gehäuseausformung am freien Ende und daß sich zumindest Abschnitte des Freiraums der Gehäuseausformung auf einen Innendurchmesser verengen, die kleiner als der Außendurchmesser des Stiftes sind.

4. Befestigungsanordnung nach einem der Ansprüche 1 bis 3, dadurch gekennzeichnet, daß die Platte (12; 22; 32; 42) eine Schaltungsträgerplatte ist.

5. Befestigungsanordnung nach einem der Ansprüche 1 bis 4, dadurch gekennzeichnet, daß das Gehäuse (11) bei im Gehäuse (11) befestigter Platte (12) über einen Deckel (16) verschließbar ist, der einen Absatz (17) aufweist, der bei verschlossenem Gehäuse (11) und eingeschobenem Stift (13) auf der Stirnseite (18) des freien Endes des Stiftes (13) spielfrei anliegt.

6. Befestigungsanordnung nach einem der Ansprüche 1 bis 4, dadurch gekennzeichnet, daß zum Verschließen des Gehäuses (41) ein Deckel (47) vorgesehen ist, an dessen Unterseite der Stift (43) angeformt ist.

7. Befestigungsanordnung nach einem der Ansprüche 1 bis 6, dadurch gekennzeichnet, daß der Stift (33) auf der Außenumfangsfläche aufgerauhte Abschnitte (39) und/oder Vorsprünge (38) aufweist.

8. Befestigungsanordnung nach einem der Ansprüche 1 bis 7, dadurch gekennzeichnet, daß der Stift (13; 23; 33; 43) und das Gehäuse (11; 21; 31; 41) aus Kunststoff oder aus einem Karbonfaserverbundmaterial hergestellt ist.

9. Befestigungsanordnung nach einem der Ansprüche 1 bis 8, dadurch gekennzeichnet, daß die Gehäuseausformungen (24) radial verlaufende Schlitze (27) aufweisen, die sich in axialer Richtung der Gehäuseausformungen (24) zumindest abschnittsweise erstrecken.
